(19) Europäisches Patentamt
European Patent Office
Office européen des brevets

(11) **EP 1 159 767 B1**

(12) **EUROPÄISCHE PATENTSCHRIFT**

(45) Veröffentlichungstag und Bekanntmachung des Hinweises auf die Patenterteilung:
**29.10.2008 Patentblatt 2008/44**

(21) Anmeldenummer: **99973753.9**

(22) Anmeldetag: **10.09.1999**

(51) Int Cl.:
**_H01L 39/24_** _(2006.01)_

(86) Internationale Anmeldenummer:
**PCT/EP1999/006680**

(87) Internationale Veröffentlichungsnummer:
**WO 2000/052768 (08.09.2000 Gazette 2000/36)**

(54) **VERFAHREN ZUM VERGÜTEN EINES SUPRALEITERMATERIALS MIT HOHER REMANENZINDUKTION UND DESSEN VERWENDUNG**

METHOD FOR COATING A SUPERCONDUCTOR MATERIAL HAVING HIGH REMANENT INDUCTION AND THE USE THEREOF

PROCEDE DE TRAITEMENT D'AMELIORATION D'UN MATERIAU SUPRACONDUCTEUR PRESENTANT UNE INDUCTION RESIDUELLE ELEVEE ET SON UTILISATION

(84) Benannte Vertragsstaaten:
**AT BE CH CY DE DK ES FI FR GB GR IE IT LI LU MC NL PT SE**

(30) Priorität: **27.02.1999 DE 19908597**

(43) Veröffentlichungstag der Anmeldung:
**05.12.2001 Patentblatt 2001/49**

(73) Patentinhaber: **Nexans SuperConductors GmbH 50351 Huerth (DE)**

(72) Erfinder:
• **BÄCKER, Michael**
  **D-50677 Köln (DE)**
• **BOCK, Joachim**
  **D-50374 Erftstadt (DE)**

• **FREYHARDT, Herbert**
  **D-37085 Göttingen (DE)**
• **LEENDERS, Andreas**
  **D-37083 Göttingen (DE)**
• **ULLRICH, Martin**
  **D-35633 Lahnau-Atzbach (DE)**
• **WALTER, Heribert**
  **D-37081 Göttingen (DE)**

(74) Vertreter: **Ahrens, Gabriele Patentanwälte Einsel & Kollegen Jasperallee 1A 38102 Braunschweig (DE)**

(56) Entgegenhaltungen:
**EP-A- 0 486 698      EP-A- 0 837 513
DE-A- 4 243 053**

**Beschreibung**

Die Erfindung betrifft ein Verfahren zum Vergüten eines Supraleitermaterials, das vergütete, nur ein Korn oder wenige Körner bzw. eine oder mehrere magnetische Domänen enthaltende Supraleitermaterial auf der Basis von (Y/SE) BaCuO mit hohen Werkstoffeigenschaften, insbesondere mit hoher Remanenzinduktion, und die Verwendung des vergüteten Materials.

Bei der Weiterentwicklung von supraleitenden Materialien ist es das Ziel, möglichst hohe supraleitende und magnetische Eigenschaften zu erzeugen. Besondere Vorteile ergeben sich, wenn texturierte polykristalline oder nur ein oder wenige magnetische Domänen aufweisende supraleitende Materialien eingesetzt werden. Am besten sind die magnetischen Eigenschaften, wenn der Formkörper nur eine magnetische Domäne aufweist.

Ein wichtiges Einsatzgebiet von sogenannten massiven formkörpern von Hochtemperatursupraleitern sind berührungsfrei arbeitende, selbststabilisierende Magnetlager. Solche Lager enthalten Anordnungen von Permanentmagneten und hochtemperatursupraleitenden Formkörpern:

Wenn sich ein hochtemperatursupraleitender Formkörper oberhalb seiner Sprungtemperatur $T_c$ im Feld eines Permanentmagneten befindet, wird er von einem magnetischen Fluß durchdrungen. Wird der Supraleiter dabei auf Temperaturen unterhalb der Sprungtemperatur abgekühlt, bleibt ein Teil des magnetischen Flusses im Supraleitermaterial eingefroren. Eine Verschiebung des hochtemperatursupraleitenden Formkörpers ist in diesem Zustand nur unter Kraftaufwendung möglich. Die Stabilität eines solchen Lagers ist umso größer, je mehr magnetischer Fluß im Supraleitermaterial eingefroren werden kann, das heißt, je höher der maximale Wert der Remanenzinduktion ist.

Verbesserte magnetische Eigenschaften wie z.B. höhere Werte der Remanenzinduktion und der Levitationskraft ermöglichen z.B. die Konstruktion von Magnetlagern mit größerem Spalt zwischen den supraleitenden Komponenten und den Permanent- bzw. Elektromagneten. Dadurch können z.B. im Falle von Motoren mit supraleitenden Komponenten größere Unwuchten bzw. Abweichungen vom idealen Lauf der Rotoren zugelassen werden. Im Falle der Lagerung der Schwungmasse in Schwungmassespeichem auf solchen Lagern können durch eine Vergrößerung des Spaltes die Sicherheitsreserven vergrößert bzw. einfachere, technisch und ökonomisch weniger aufwendig zu konstruierende Lagergeometrien akzeptiert werden.

Es besteht ein Bedarf für Formkörper mit guten supraleitenden und magnetischen Eigenschaften sowie einer ausreichenden mechanischen Stabilität, die ggf. auch für einen vorgegebenen Wert der Remanenzinduktion möglichst nicht von zu großem Formkörpervolumen sein sollen und daher eine möglichst hohe Magnetisierungskraft aufweisen sollen, um leichter in entsprechende Anlagen eingepaßt zu werden. Vor allem besteht ein Bedarf, mit Formkörpern einerseits von wenigen Quadratzentimetem Fläche, andererseits mit deutlich größeren, evtl. segmentierten Formkörpern wie z.B. Ringen, starke Magnete für den Temperaturbereich bis zu 77 K hoch bereitzustellen, der Temperatur des flüssigen Stickstoffs.

Eine Möglichkeit, die Remanenzinduktion eines solchen Formkörpers zu erhöhen, kann in der Vergrößerung der magnetischen Domänen durch Prozessieren größerer eindomäniger Formkörper erfolgen. Das ist jedoch wegen der geringen Wachstumsraten der Phase $(Y,SE)_1Ba_2Cu_3O_{7-x}$ (= Phase 123) mit sehr langen Prozeßzeiten verbunden. Zudem wird die Wachstumsfront in Formkörpern auf Basis (Y/SE)BaCuO mit weitgehend homogener Ausgangszusammensetzung mit zunehmender Größe der Körner instabil.

Morita et al., Mater. Sci. Eng. B53, 1998, 159-163, begegnen dem durch die Verwendung von Formkörpern mit gezielt eingestellter, nicht homogener Ausgangszusammensetzung, bei denen ein stärkerer chemischer Gradient im Formkörper erzeugt wird. Es wurden YBaCuO-Formkörper mit einem aufgesetzten Dy-haltigen großflächigen Formkörper hergestellt. Auf dem Dy-reichen Formkörper saß wiederum ein Sm-haltiger Keim auf. Hierbei wurden maximale Werte der Remanenzinduktion von 1080 mT bei 77 K und 0 T erreicht. Bei diesem Verfahren wird zunächst der Dyreiche Formkörper texturiert. Dieser Formkörper dient anschließend als großflächiger Keim für die Texturierung des Yreichen Formkörpers. Dies bedeutet, daß hier zwei vollständige Texturierungsverfahren mit allen dazu notwendigen Prozeßschritten durchgeführt werden müssen, was eine deutliche Erhöhung der Prozeßzeit bedingt.

Zudem ist aus der Herstellung der Formkörper auf Y-Basis bekannt, daß nur selten ein vollständiges Durchwachsen des zentralen Korns erreicht werden kann. In der Regel wird dieses zentrale Korn zu den Seiten und nach unten hin von einer nicht texturierten Schicht von etwa 1 bis 2 mm Dicke umgeben, in der die vor der Wachstumsfront hergeschobenen Partikel in der Restschmelze erstarren. Es wird davon ausgegangen, daß dies auch beim Wachstum von Dy-reichen Formkörpern nach der von Morita et al. beschriebenen Methode der Fall war. In solchen Fällen ist kein Texturübertrag vom Dy-reichen Formkörper auf den Y-reichen Formkörper möglich. Der Y-reiche Formkörper würde dann polykristallin aufwachsen und entsprechend schlechte supraleitende Eigenschaften aufweisen. Es ergäbe sich dann bei diesem Verfahren eine sehr hohe Ausschußquote.

Die Herstellung von geeigneten Vorläufermaterialien für das Prozessieren sowie das Prozessieren der kombinierten Formkörper sind sehr aufwendig und bringen eine zusätzliche Verlängerung der Prozessierzeiten mit sich. Außerdem ist es für einige Anwendungen notwendig, die Größe der supraleitenden Formkörper möglichst gering zu halten, insbesondere, wenn sie in bestehende Anlagenkonstruktionen einzupassen sind.

Eine Vergrößerung der magnetischen Domänen ohne Vergrößerung der Formkörper kann in mit Rissen oder/und anderen Fehlstellen versehenen Formkörpern auch durch das Ausheilen solcher Fehlstellen nach dem in der Deutschen Patentanmeldung 198 41 925.2 (korrespondierend zu WO 00/15581) beschriebenen Verfahren erreicht werden.

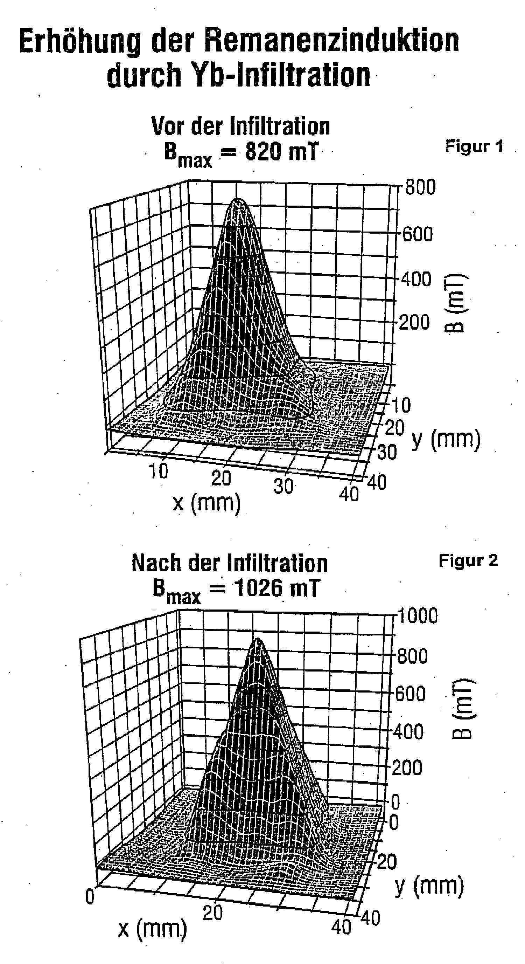

Ferner sind aus Ikuta et al., Supercond. Sci. Techn. 11, 1998, 1345-1347, Formkörper auf Basis SmBaCuO bekannt, die einen hohen Anteil an $Ag_2O$ enthalten und eine Remanenzinduktion von bis zu 1700 mT ergaben: Solch ein Sm-reiches Supraleitermaterial kann jedoch nur recht schwierig und nicht an Luft hergestellt werden, da die supraleitende Phase Sm-123 unter solchen Bedingungen nicht stabil ist. Die Formkörperherstellung muß daher unter einer Schutzgasatmosphäre mit geringem Sauerstoffpartialdruck vorgenommen werden. Ferner wird in der Figur 2 dieser Publikation ein Vergleich zu YBaCuO-Formkörpern gezogen, deren Remanenzinduktion noch nicht einmal halb so groß ist wie die der Formkörper auf Basis SmBaCuO.

In EP 1011153 A2 (eine Druckschrift nach Artikel 54 (3) EPÜ) ist ein oxydischer Supraleiter und ein Verfahren zu dessen Herstellung beschrieben, wobei der Supraleiter mit einer Kunstharzschicht imprägniert ist.

Es bestand daher die Aufgabe, ein Verfahren vorzuschlagen, mit dem solche Supraleftermaterialien hoher Remanenzinduktion, hoher Levitationskraft oder/und hoher kritischer Transportstromdichte hergestellt werden können. Ferner ist es vorteilhaft, wenn diese Formkörper möglichst einfach und zuverlässig gefertigt werden können.

Die Aufgabe wird gelöst mit einem Verfahren zum Vergüten von Formkörpern aus einem Supraleitermaterial auf Basis SEBaCuO mit SE mindestens ein Seltenerdelement einschließlich Lanthan und Yttrium, das dadurch gekennzeichnet ist, daß auf mindestens einen Teil eines Bereichs einer Oberfläche des Formkörpers eine Beschichtung aus einem Auftragsmaterial aufgebracht wird, wobei das Auftragsmaterial zumindest teilweise bei einer tieferen Temperatur als das Formkörpermaterial schmilzt oder/und bei einer tieferen Temperatur als jenes Material fließfähig ist und hierbei ggf. auf der Oberfläche des Formkörpers ausfließt, wobei der Formkörper mit dem aufgebrachten Auftragsmaterial auf eine Temperatur aufgeheizt wird, bei der das Formkörpermaterial noch nicht schmilzt oder/und noch nicht fließfähig ist, aber bei der das Auftragsmaterial im zumindest teilweise aufgeschmolzenen oder/und fließfähigen Zustand ist und wobei mindestens ein Teil eines Oberflächen-nahen Bereiches des Formkörpers bei dieser Temperatur oder/und einem nachfolgenden Abkühlen modifiziert wird, indem das Auftragsmaterial ganz oder teilweise zumindest den Oberflächen-nahen Bereich des Formkörpers infiltriert, und bei dem der derart behandelte Formkörper beim

Abkühlen oder/und bei einer nachfolgenden Wärmebehandlung mit Sauerstoff angereichert wird, wobei die Modifizierung zur Erhöhung der Remanenzinduktion oder/und der kritischen Stromdichte des mit Sauerstoff angereicherten Formkörpers beiträgt, und wobei das Auftragsmaterial mindestens ein Seltenerdelement, ausgewählt aus der Gruppe bestehend aus Y, La, Ce, Pr, Nd, Eu, Gd, Tb, Dy, Ho, Er, Tm, Yb und Lu, sowie mindestens ein Erdalkalielement, Kupfer und Sauerstoff enthält.

Das Supraleitermaterial enthält mindestens eine supraleitende oder supraleitfähige Phase, wobei die supraleitfähige Phase bei entsprechender Anreicherung mit Sauerstoff zu einer supraleitenden Phase wird. Es enthält vorzugsweise mindestens ein Seltenerdelement (einschließlich Lanthan und Yttrium) sowie mindestens Barium, Kupfer und Sauerstoff und gegebenenfalls auch Elemente aus der Gruppe von Be, Mg, Ca, Sr, Zn, Cd, Sc, Zr, Hf, Pt, Pd, Os, Ir, Ru, Ag, Cu, Au, Hg, Ag, Tl, Pb, Bi und S. Die dreiwertigen Elemente dienen dabei bevorzugt als Ersatz von Yttrium und die zweiwertigen bevorzugt zur Modulation der Elektronenstruktur bzw. zum teilweisen Ersatz von Barium. Seltenerdelemente SE im Sinne dieser Anmeldung schließen auch Lanthan und Yttrium mit ein. Unter den Seltenerdelementen sind Y, La, Ce, Nd, Sm, Pr, Eu, Gd, Yb, Dy, Er bevorzugt, wobei Ce, Pr und Sm nur als Anteil an Mischkristallen neben anderen Seltenerdelementen bevorzugt sind. Cer kann dabei zur Verfeinerung der Partikel der 211-Phase und ähnlicher Pinning-Zentren dienen. Besonders bevorzugt sind Y, Yb, Dy, Er und Nd.

Ein Material des Formkörpers oder/und ein Auftragsmaterial ist ausgewählt aus der Gruppe von Materialien auf Basis von Y-Ea-Cu-O, SE-Ea-Cu-O, SE-Ea-Cu-O, wobei Anteile dieser chemischen Elemente durch andere, nicht genannte substituiert sein können und wobei Ea für mindestens ein Erdalkalielement steht.

Als hochtemperatursupraleitende Materialien eignen sich für das erfindungsgemäße Verfahren solche, bei denen das zu modifizierende bzw. das modifizierte Supraleitermaterial des Formkörpers oder/und das Auftragsmaterial Phasen enthält, die ausgewählt sind aus der Gruppe von Phasen mit einer annähernden Zusammensetzung von $Y_1Ba_2Cu_3O_v$, $Y_2Ba_1Cu_1O_w$, $Yb_1Ba_2Cu_3O_{v'}$, $Yb_2Ba_1Cu_1O_{w'}$, $Sm_1Ba_2Cu_3O_{v''}$, $Sm_2Ba_1Cu_1O_{w''}$, $Nd_1Ba_2Cu_3O_{v'''}$, $Nd_4Ba_2Cu_2O_{w'''}$, $Dy_1Ba_2Cu_3O_{v''''}$, $Dy_2Ba_1Cu_1O_{w''''}$, $Er_1Ba_2Cu_3O_{v'''''}$, $Er_2Ba_1Cu_1O_{w'''''}$, $Eu_1Ba_2Cu_3O_{w''''''}$, $Eu_2Ba_1Cu_1O_{w''''''}$, $Gd_1Ba_2Cu_3O_{v'''''''}$, $Gd_2Ba_1Cu_1O_{w'''''''}$, $Y_2O_3$, $CeO_2$, Pt, $PtO_2$, Ag und $AgO_2$, wobei Y, Yb, Sm oder/und Nd teilweise auch durch andere Lanthaniden einschließlich Y substituiert sein können und wobei Ag, $AgO_2$ oder/und auch andere verwandte chemische Elemente auftreten können.

Es ist bekannt, daß alle diese supraleitenden Phasen oft eine Zusammensetzung aufweisen, die von der Stöchiometrie der jeweiligen allgemeinen Formel signifikant abweicht. Die Zusammensetzung dieser Phasen und die Substitution durch andere chemische Elemente ist dem Fachmann grundsätzlich bekannt.

Der unbehandelte oder/und der behandelte Formkörper des Supraleitermaterials, das Auftragsmaterial oder/und das Schichtmaterial können zusätzlich Calcium oder/und andere Kationen aufweisen, die die Bandstruktur der Elektronen verändern und zu höheren kritischen Transportstromdichten beitragen. Der Formkörper des Supraleitermaterials oder/und das Auftragsmaterial können auch mindestens einen Gradienten bezüglich der chemischen Zusammensetzung, des Gefüges oder/und der peritektischen, Fließ- oder Schmelztemperatur aufweisen.

Körner (= sogenannte kristallographische "Domänen") im Sinne dieser Anmeldung werden durch mindestens eine Komgrenze voneinander getrennt oder/und weisen unterschiedliche kristallographische Orientierungen auf.

Magnetische Domänen im Sinne dieser Anmeldung werden durch mindestens eine Domänengrenze voneinander getrennt, wobei die Domänen auch gleichartig orientiert sein können und sogar einem einzigen Korn angehören können, wobei die Domänengrenze ggf. nur durch einen Fehler wie einen Riß (= Domänengrenze) zwischen zwei verschiedenen magnetischen Bereichen gebildet wird. Die magnetischen Domänen entsprechen dabei nicht notwendigerweise wie bei Permanentmagneten üblich Bereichen ausgerichteter magnetischer Momente, sondern werden je nach den Bedingungen des zum Aufmagnetisieren angewandten Feldes orientiert. Die magnetischen Domänen werden in dieser Anmeldung im weiteren nur als "Domänen" bezeichnet.

Ziel der Weiterentwicklung und Optimierung derartiger Formkörper ist es, möglichst hohe Werte der Remanenzinduktion und der kritischen Transportstromdichte zu erzeugen, was beim gleichen technischen Einsatz die Verwendung von kleineren erfindungsgemäß modifizierten Formkörpern ermöglicht. Falls der Formkörper nach der Texturierung eine inhomogene Verteilung supraleitender Eigenschaften, insbesondere zu den Randbereichen hin, aufweist, so ist der Formkörper insbesondere im Randbereich nach dem erfindungsgemäßen Verfahren stärker oder in besonderer Weise zu modifizieren, um eine Homogenisierung der Verteilung der supraleitenden Eigenschaften zu erreichen.

Formkörper als Vorläufermaterial für das erfindungsgemäße Verfahren, die nur mit einem Korn oder mit wenigen Körnern bzw. mit nur einer magnetischen Domäne oder mit wenigen magnetischen Domänen versehen sind, werden vorzugsweise in einem modifizierten Schmelztexturwachstumsverfahren wie z.B. dem Melt-textured-growth-Verfahren, in einem Top-seeded-melt-growth-Verfahren mit einem oben aufsitzenden Keim, in einem Zonenschmelzverfahren wie dem Vertical-gradient-freeze-Verfahren oder in einem Einkristallzüchtungsverfahren wie z.B. dem modifizierten Bridgeman-Verfahren hergestellt. Formkörper, die in einem dieser Verfahren hergestellt wurden, weisen manchmal nur ein bis sechs magnetische Domänen auf. Wenn derartige Proben Risse oder/und verunreinigte oder strukturell gestörte Bereiche aufweisen, können diese Defekte verfüllt oder/und ausgeheilt werden, und auch die aufgespaltenen magnetischen Domänen können ausgeheilt werden.

Diese Verfahren, die der Herstellung eines Vorläufermaterials auf Basis von SEBaCuO für das erfindungsgemäße Verfahren dienen, haben üblicherweise folgendes vereinfacht gemein:

Zunächst werden die z.B. vorgesinterten Formkörper auf Basis von SEBaCuO auf eine Temperatur aufgeheizt, die oberhalb der peritektischen Temperatur oder Schmelztemperatur des entsprechenden Vorläufermaterials liegt. Diese Temperatur wird so lange gehalten, bis das gesamte Vorläufermaterial in den teilweise schmelzflüssigen Zustand übergegangen ist, in dem z.B. die $Y_2Ba_1C_1uO_5$-Phase mit einer Ba- und Cu-reichen Schmelze im Gleichgewicht steht Der darauf folgende Verfahrensabschnitt kann der eigentliche Texturierungsschritt sein. Er bestimmt das Wachstum der Körner und damit die Gefügestruktur des resultierenden Formkörpers. Hier kommen die Unterschiede der einzelnen Verfahren zum Ausdruck. Abschließend erfolgt die wieder allen Verfahren gemeinsame Abkühlung, bei der die Temperatur wieder auf Raumtemperatur zurückgeführt wird. Bei diesem Abkühlen kann eine Anreicherung mit Sauerstoff erfolgen, vor allem bei einem langsamen Abkühlen im Temperaturbereich von etwa 500 bis 350 °C bzw. bei einer Haltezeit in diesem Temperaturbereich unter Verwendung eines fließenden Sauerstoff-reichen Gasstromes. Anderenfalls muß der Formkörper nach der Texturierung in mindestens einer weiteren Wärmebehandlung mit Sauerstoff angereichert werden. Die Gefügestruktur der so hergestellten Formkörper wird je nach Verfahren aus einem oder mehreren Körnern gebildet. Diese Körner setzen sich ihrerseits aus Platten zusammen, die durch Kleinwinkelkorngrenzen von weniger als 1 ° voneinander getrennt sind. Je nach dem Herstellungsverfahren und der Zusammensetzung des Ausgangsmaterials sind kugel- oder nadelförmige Partikel der Phase 211 mit Durchmessern von etwa 100 nm bis zu 100 μm im ganzen Formkörper verteilt. Im folgenden werden die charakteristischen Verfahrensschritte und -merkmale der wichtigsten Texturierungsverfahren dargestellt:

1.) Melt-textured-growth-Verfahren (MTG):

Dieses Verfahren ist ein nicht gerichtetes Texturierungsverfahren ohne räumlichen Temperaturgradienten. Die Texturierung erfolgt vor allem durch langsames Abkühlen des Formkörpers aus dem teilweise schmelzflüssigen Zustand heraus auf Temperaturen unterhalb der peritektischen bzw. Schmelztemperatur. In diesem Abkühlschritt bilden sich Körner z.B. der Phase $SE_1Ba_2Cu_3O_{7-x}$ aus, deren Größe und Anzahl je Volumeneinheit (= Anzahldichte) von der gewählten Abkühlrate stark abhängt Die kristallographische Orientierung dieser Körner ist weitgehend regellos verteilt, wobei viele Großwinkelkomgrenzen im Formkörper vorhanden sein können.

2.) Vertical-gradient-freeze-Verfahren (VGF):

Dieses Verfahren ist ein gerichtetes Schmelztexturierungsverfahren. Ein aus z.B. acht einzeln regelbaren Zonen aufgebauter stationärer Ofen wird so angesteuert, daß ein Temperaturprofil durch die ebenfalls stationär gehaltene Probe geführt wird. Der vertikale Temperaturgradient kann dabei z.B. 25 K/cm betragen. Im Bereich der peritektischen Temperatur bzw. Schmelztemperatur wird oft mit etwa 1 K/h abgekühlt. Die dabei entstehenden schmelztexturierten Formkörper enthalten im zuerst aufgeschmolzenen Bereich bedingt durch die regellose Keimbildung mehrere Körner. Dabei setzen sich in dem auf die Keimbildung folgenden Kornwachstum solche Körner durch, deren c-Achsen im wesentlichen parallel zu dem bei der Herstellung vorherrschenden Temperaturgradienten ausgerichtet sind. Der Orientierungsunterschied zwischen solchen bevorzugt wachsenden Körnern kann dabei bis zu etwa 15 ° betragen.

3.) Modifiziertes Bridgeman-Verfahren:

Bei diesem Verfahren kann die Probe bevorzugt vertikal in Beziehung zu einem stationären, oft aus drei Zonen bestehenden Ofen bewegt werden. Dabei kann die Probe entweder durch eine geeignete Unterlagenkonstruktion wie z.B. durch einen Tiegel gestützt oder an einer Zugvorrichtung aufgehangen werden. Die Temperatur der oberen Zone beträgt oft typischerweise etwa 850 °C, die der mittleren etwa 1150 °C und die der unteren Zone etwa 750 °C. Im Bereich der peritektischen Temperatur wird so ein Gradient von beispielsweise etwa 20 K/cm erzeugt, durch den die Probe mit einer Geschwindigkeit von z.B. 1 mm/h hindurchgeführt werden kann. Dies entspricht dann einer Abkühlrate von etwa 2 K/h.

Die zylindrischen Proben sind oft etwa 12 cm lang und haben oft einen Durchmesser von etwa 6 mm. Unterhalb einer ca. 2 bis 3 cm langen Keimbildungszone, in der unterschiedlich orientierte Körner im Wachstum konkurrieren, sind die Proben üblicherweise eindomänig und weisen dann zwangsläufig nur ein Korn auf. Die c-Achse ist in diesem eindomänigen Bereich oft um etwa 45 ° gegen die Probenachse geneigt.

4.) Top-seeded-melt-growth-Verfahren (TSMG):

Dieses Verfahren ermöglicht die Herstellung von kristallographisch eindomänigen Formkörpern mit einer kristallographischen Orientierung, die durch die Orientierung des auf die Oberfläche des Vorläufermaterials aufzubringenden geeigneten Impfkristalls (Keim) vorgegeben werden kann. Der Impfkristall muß dabei aus einem Material bestehen, das auch bei Temperaturen oberhalb der peritektischen oder Schmelztemperatur des zu texturierenden Materials noch in kristalliner Form vorliegt. Für die Beherrschung der Orientierung müssen die Gitterparameter des Keimmaterials näherungsweise denen des zu texturierenden Materials entsprechen. Das Aufbringen des Keimes kann dabei vor dem eigentlichen Texturierungsschritt durch Einpressen, Versintern oder einfach durch Auflegen sowie während des Texturierungsverfahrens durch Auflegen auf die bereits erhitzte Probe erfolgen.

Das so mit einem Keim versehene Vorläufermaterial wird in einen teilweise schmelzflüssigen Zustand überführt und rasch auf eine Temperatur unterhalb der peritektischen oder Schmelztemperatur des zu texturierenden Materials abgekühlt, bei der im direkten Kontakt zum Impfkristall eine Keimbildung und ein Wachstum insbesondere der Körner der Phase $SE_1Ba_2Cu_3O_{7-x}$ einsetzt, die Unterkühlung in anderen Bereichen des Formkörpers für die Keimbildung und das Kornwachstum noch nicht ausreicht. Bei dieser Temperatur wird oft eine Haltezeit im Temperaturprofil gewählt, um das Wachstum des zentralen Korns zu stabilisieren. Die darauffolgende Temperaturführung muß vor allem darauf abzielen, die entstehende Kristallisationswärme abzuführen und das stabile Wachstum des zentralen Korns zu erhalten und das Wachstum weiterer Körner zu unterdrücken. Das kann durch eine ausreichend langsame Abkühlung und/oder das Einfügen weiterer Haltezeiten erreicht werden.

Die so hergestellten Proben bestehen aus einem einzigen Korn mit einer Orientierung, die der durch den Impfkristall vorgegebenen im wesentlichen entspricht. In der Regel wird dabei eine Ausrichtung der c-Achse senkrecht zu einer der Flächen der Geometrie des Formkörpers bevorzugt. Die Substruktur dieser Körner wird wie bei den anderen Verfahren zur Ausbildung eines Vorläufermaterials im wesentlichen aus plattenförmigen Körnern gebildet, die durch Kleinwinkelkomgrenzen von weniger als 1° voneinander getrennt sind.

Erfindungsgemäßes Vergütungsverfahren:
Mit dem nachstehend beschriebenen Vergütungsverfahren lassen sich die Supraleitereigenschaften wie Remanzinduktion, Levitationskraft und/oder-Höhe der kritischen-Stromdichte der vorstehend erhaltenen Formkörper als Vorläufermaterial für das erfindungsgemäße Vergütungsverfahren durch Modifikation der Oberfläche des Formkörpers verbessern.

Hierzu wird auf den Formkörper ein Auftragsmaterial aufgebracht, das während des Brandes mindestens teilweise ausläuft und ggf. sogar auf der Fläche des Formkörpers spreitet.

Für die Auswahl des Materials eines Keimes, eines Supraleitermaterials, eines Auftragsmaterials, das beim Brand in das Schichtmaterial übergehen bzw. mit diesem chemisch identisch sein kann, und eines Schichtmaterials ergibt sich folgende Temperaturabfolge, wobei mit T die jeweilige peritektische oder Schmelztemperatur gemeint ist und wobei die Verwendung eines Keimes nur zur Herstellung eines geeigneten Vorläufermaterials für das erfindungsgemäße Vergütungsverfahren dient

$$T_{Keimmaterial} > T_{Supraleitermaterial} > T_{Schichtmaterial.}$$

Für die Phasen der allgemeinen Zusammensetzung $SE_1Ba_2Cu_3O_{7-x}$ gelten näherungsweise folgende peritektische bzw. Schmelztemperaturen (Tabelle 1):

| SE | Tp (°C) |
|----|---------|
| La | 1090 |
| Nd | 1090 |
| Sm | 1060 |
| Eu | 1050 |
| Gd | 1030 |
| Dy | 1010 |
| Y | 1000 |
| Ho | 990 |
| Er | 980 |
| Tm | 960 |
| Yb | 900 |
| Lu | 880 |

Die Tabelle 1 gibt grundsätzlich Anhaltslinien zur Auswahl der geeigneten Paarungen von Elementen. Gemische verschiedener Elemente, der Einsatz von Druck bzw. Unterdruck, Gehalte an Substanzen, die den Schmelzpunkt oder die peritektische Temperatur absenken, und insbesondere der Sauerstoffpartialdruck können jedoch eine deutliche Temperaturwertänderung und ggf. auch eine Änderung der in der Tabelle 1 aufgeführten Reihenfolge bedingen.

Es ergeben sich folgende Paarungen als bevorzugte Paarungen der für SE beteiligten Elemente für die Temperaturabfolge und für die Auswahl der Materialien, die vor allem Phasen der allgemeinen Zusammensetzung $SE_1Ba_2Cu_3O_{7-x}$ enthalten (Tabelle 2):

| Keim | | Supraleitermaterial | | Schichtmaterial |
|------|---|---------------------|---|-----------------|
| Nd | > | Sm | > | Dy |
| Nd | > | Dy | > | Y |
| Nd | > | Y | > | Yb |
| Nd | > | Sm | > | Yb |
| Sm | > | Y | > | Yb |
| Sm | > | Gd | > | Y |
| Eu | > | Dy | > | Er |
| Eu | > | Y | > | Yb |
| Gd | > | Y | > | Yb |
| Dy | > | Er | > | Yb |

In der Tabelle bleibt unberücksichtigt, daß das Supraleitermaterial vor der Behandlung mit einem Keim eine etwas andere Zusammensetzung und andere Eigenschaften aufweisen kann als nach der Bekeimung. Auch hierbei ist nur die Modifizierung des Supraleitermaterials mit dem Schichtmaterial erfindungsgemäß.

Das Auftragsmaterial wird vorzugsweise in einer Schichtdicke im Bereich von 1 $\mu$m und 5 mm aufgebracht, besonders bevorzugt im Bereich von 10 µm bis 3 mm, ganz besonders bevorzugt im Bereich von 50 µm und 2 mm.

Als Auftragsmaterial, das für die Beschichtung zumindest eines Teils der Oberfläche des zu modifizierenden Formkörpers vorgesehen ist, kann ein Pulver, ein Formkörper oder/und eine Beschichtung aufgebracht werden; als Formkörper vorzugsweise ein gepreßter, kalzinierter, gesinterter oder erschmolzener, ggf. texturierter oder schmelztexturierter Formkörper und als Beschichtung vorzugsweise eine physikalisch oder/und chemisch abgeschiedene, im wesentlichen durch Fällen, Zersetzungsreaktion, Sprühen bzw. Sprühpyrolyse hergestellte Beschichtung wie z.B. Laserablation, Gasphasenabscheidung, Sputtern, Aufdampfen, Zerstäuben, CVD, PVD, Sol-Gel-Verfahren. Hierbei können Oxide, Hydroxide, Carbonate, Nitrate und ähnliche Precursormaterialien wie Citrate und Oxalate verwendet werden, aber auch Materialien zur Schmelzpunktsabsenkung wie Halogenide, insbesondere Fluoride. Insbesondere bei im Vergleich zum Supraleitetermaterial im wesentlichen arteigenen Material ist es erforderlich, daß das Auftragsmaterial einen geringeren Schmelzpunkt oder peritektischen Punkt aufweist als das zu modifizierende Supraleitermaterial, weshalb sich ein Zusatz empfiehlt, mit dem der Schmelzpunkt erniedrigt bzw. die peritektische Temperatur abgesenkt werden kann.

Ein pulverförmiges Auftragsmaterial, zu dem auch ein einphasiges oder mehrphasiges Pulver, eine Pulvermischung oder/und ein Granulat gezählt wird, kann u.a. aufgestreut oder aufgestrichen werden; ein Formkörper des Auftragsmaterials kann auf die entsprechende Oberfläche des Formkörpers des Supraleitermaterials aufgesetzt bzw. geklebt werden; z.B. aus der Gasphase heraus oder mit einem Aerosol kann die Beschichtung des zu modifizierenden Formkörpers vorgenommen werden.

Der beschichtete Formkörper des Supraleitermaterials kann so lange bei einer Temperatur gehalten werden, bei der das Formkörpermaterial noch nicht schmilzt oder/und noch nicht fließfähig ist, aber bei der das Auftragsmaterial im zumindest teilweise aufgeschmolzenen oder/und fließfähigen Zustand ist und wobei mindestens ein Teil eines Oberflächen-nahen Bereiches des Formkörpers bei dieser Temperatur oder/und einem nachfolgenden Abkühlen modifiziert wird, so daß ein Teil des Auftragsmaterials in das zu modifizierende Supraleitermaterial eindiffundieren bzw. eindringen kann. Hierbei können auch Oberflächendefekte z.B. Poren, Risse und Mikrorisse, die ggf. in dem zu modifizierenden Oberflächenbereich vorhanden sind, geschlossen werden und kann eine feste Verzahnung durch chemische oder physikochemische Reaktionen an den Grenzflächen auftreten. Ferner können bestimmte Elemente auch tiefer in das zu modifizierende Supraleitermaterial eindiffundieren. Das Auftragsmaterial kann u.U. weitestgehend eindiffundieren, eindringen und ggf. untergeordnet verdampfen, so daß bei dünneren Beschichtungen evtl. nur eine sehr dünne Restschicht oder gar keine restliche Schicht mehr auf dem modifizierten Formkörper nach dem Brand übrigbleibt. Bei der Modifizierung des Supraleitermaterials kann einerseits im Formkörper des Supraleitermaterials oder/und andererseits im aus dem Auftragsmaterial erzeugten Schichtmaterial ein Gradient erzeugt werden, z.B. als Gradient eines bestimmten Elementes, der auch die Eigenschaften des Materials graduell beeinflussen kann.

Aufgrund der Modifizierung und Kristallisation bildet sich oft auf der modifizierten Fläche des Formkörpers im Brand eine Pyramide mit sehr flachen Flanken aus. Der restliche Keim, das Schichtmaterial, die in Form einer sehr flach ausgebildeten Pyramide gewachsenen Kristallflächen oder/und die Unebenheit des erzeugten Formkörpers werden danach vorzugsweise mechanisch entfernt, z.B. durch Sägen, Schleifen, Läppen oder/und Polieren, und ggf. nachträglich einer Wärmebehandlung unterzogen, die der Sauerstoffanreicherung oder/und dem Ausheilen des Materials dienen kann.

Der zu modifizierenden Formkörper weist vorzugsweise eine relative Dichte von mindestens 80 % auf, besonders bevorzugt von mindestens 95 %, jedoch können in Ausnahmefällen auch weniger dichte Formkörper Vorteile bieten, wenn sie erfindungsgemäß behandelt werden.

Der Formkörper des Supraleitermaterials kann während der Brände und Wärmebehandlungen so gesetzt werden, daß er außer zum Auftragsmaterial nur in direktem Kontakt mit einem Material auf Basis SEBaCuO steht, vorzugsweise mit einem Material von Phasen auf Basis $Y_2BaCuO_5$. Dies hilft, Kontaktreaktionen und ein partielles Zerfließen des supraleitenden Formkörpers beim Brand bzw. das Auftreten mechanischer Spannungen zu vermeiden. Feuerleichtsteine sowie Brennhilfsmittel auf Basis MgO oder $Al_2O_3$ sind daher weniger geeignet.

Die Abkühlung nach bzw. beim Modifizieren des Supraleitermaterials sowie nach einer nachträgliche Wärmebehandlung erfolgt möglichst langsam, um die Ausbildung von Rissen, Mikrorissen und Abplatzungen zu vermeiden.

Der Formkörper kann während des Abkühlens oder/und während einer erneuten Wärmebehandlung mit Sauerstoff angereichert werden, um die supraleitenden Eigenschaften zu erzeugen oder/und zu verbessern. Die Modifizierung des Supraleitermaterials kann zur Ausbildung von Defekten im Kristallgitter des Formkörpers führen, die zur Steigerung der magnetischen Eigenschaften beitragen. Hierbei kann es sich um Punktdefekte, insbesondere Fehlstellen aufgrund des Einbaus zu großer oder zu kleiner Kationen in das üblicherweise tetragonale Perowskit-Kristallgitter, Leerstellen, Korngrenzen handeln, es kann aber auch zur Veränderung der Porenstruktur kommen.

In einer bevorzugten Ausgestaltung, vor allem, wenn ein Formkörper nur ein Korn oder nur wenige Körner oder/und sogar nur eine magnetische Domäne oder nur wenige magnetische Domänen aufweist, kann ein ggf. vorhandener Riß, eine Komgrenze oder/und ein verunreinigter oder strukturell gestörter Bereich entfernt werden, insbesondere durch Sägen, wobei der entfernte Bereich danach im weiteren erfindungsgemäßen Verfahren analog einem zu modifizierenden Bereich behandelt wird. Hierdurch ist es u.a. möglich, fehlerhafte Formkörper gänzlich auszuheilen und zu modifizieren oder besonders große Formkörper mit besseren Eigenschaften als derzeit technisch möglich herzustellen. Das erfindungsgemäße Verfahren kann dabei in vorteilhafter Weise so ausgeführt werden, daß das fließfähige Auftragsmaterial bei hoher Temperatur zumindest teilweise in einen Riß oder/und in einen z.B. durch Sägeschnitt entfernten Bereich des Formkörpers eindringt, die in dem zu modifizierenden Oberflächenbereich vorhanden sind.

Vorzugsweise weist der Formkörper des Supraleitermaterials vor der Modifizierung und Wärmebehandlung nur ein bis hundert Körner oder/und ein bis hundert Domänen auf, um bei der Modifizierung und ggf. bei den nachfolgenden Wärmebehandlungen die Zahl der Körner bzw. Domänen möglichst auf ein bis acht zu verringern. Je großvolumiger jedoch die Formkörper sind, desto mehr Körner bzw. Domänen können sie enthalten. Es kann sogar von einem texturierten polykristallinen Formkörper mit einer sehr hohen Anzahl an Körnern ausgegangen werden.

Vorzugsweise weist der Formkörper des Supraleitermaterials nach der Modifizierung und ggf. nach der Wärmebehandlung nur ein bis hundert Körner oder/und ein bis hundert Domänen auf, insbesondere bis 50, besonders bevorzugt nur ein bis 20, ganz besonders bevorzugt nur ein bis acht Körner bzw. Domänen oder sogar nur ein Korn und bis zu vier Domänen.

Grundsätzlich sind alle Geometrien von Formkörpern für den Einsatz im erfindungsgemäßen Verfahren bzw. nach der Modifizierung in diesen Formen für den technischen Einsatz geeignet Bevorzugt und derzeit gebräuchlich sind solche, die im wesentlichen in Form von Platten, Scheiben, Quadern, Vollzylindern, Hohlzylindern, Ringen, Rohren, Stäben, Bändern, Drähten oder Spulen vorliegen, wobei Winkelabweichungen, Kantenbrüche, Kantenabrundungen, zusätzliche Ausnehmungen wie z.B. Bohrungen und Nuten sowie zusätzliche vorstehende Partien wie Stege, Nasen und ähnliche geometrische Abwandlungen auftreten können. Platten können einen quadratischen oder rhombischen Grundriß aufzeigen.

Ein großformatiger Formkörper des Supraleitermaterials kann mehrere in Abstand zueinander stehende Keime aufweisen, deren Kristallorientierungen der c-Achsen vorteilhafterweise entweder im wesentlichen parallel zu einer der Nauptrichtungen der Geometrie des Formkörpers, z.B. im wesentlichen parallel zu der Zylinderachse eines Zylinders, oder im wesentlichen senkrecht dazu stehen. Das hat den Vorteil, daß die Vorzugsorientierung der c-Achse, zu der die Ebene besonders guter Supraleitung senkrecht steht, so angeordnet ist, daß eine höhere kritische Transportstromdichte durch die Ausrichtung in Fließrichtung des elektrischen Stromes erreicht wird, ein hoher Strom fließen kann und eine starke Magnetisierung erzielt wird. Mit der Kristallorientierung des Keims kann die Kristallorientierung im zu modifizierenden Formkörper gesteuert werden. Dann ist es auch möglich, bei einem Rohr oder Ring durch entsprechende Anordnung mehrerer Keime eine Ausrichtung der c-Achse in radialer Richtung zu erzeugen, so daß die Ebene der stärksten Supraleitung in der Rohrwandung liegt und somit für den Einsatzzweck optimal angepaßt werden kann. Das setzt aber voraus, daß in bestimmten Winkelgraden um die Zylinderachse herum eine neue Domäne oder/und ein neues Korn vorliegt, um die Orientierung entsprechend der Krümmung des Formkörpers anzupassen. Solche Formkörper bedingen dann zwangsläufig eine je nach Größe etwas erhöhte oder sogar deutlich höhere Zahl an Domänen bzw. Körnern, z.B. sechs bis vierundzwanzig.

Ein großformatiger Formkörper des Supraleitermaterials kann vorteilhafterweise in mehreren Segmenten hergestellt werden, die ggf. aneinandergepaßt oder besser sogar miteinander gefügt werden. Das Fügen kann insbesondere durch Wärmebehandlung bei einer Temperatur erfolgen, bei der das Formkörpermaterial noch nicht schmilzt oder/und noch nicht fließfähig ist, aber bei der das Auftragsmaterial im zumindest teilweise aufgeschmolzenen oder/und fließfähigen Zustand ist und wobei mindestens ein Teil eines Oberflächen-nahen Bereiches des Formkörpers bei dieser Temperatur oder/und einem nachfolgenden Abkühlen modifiziert wird - ggf. unter Druck und ggf. unter Zusatz eines Auftragsmaterials auf den miteinander zu fügenden Grenzflächen, aber auch z.B. durch eine einfache Klebung.

Für Formkörper, deren Oberflächen eine bestimmte Oberflächengüte, z.B. einen Mittenrauhwert $R_a$ bestimmter Größe oder als Funktionsflächen eine bestimmte Form der Abbot'schen Tragkurve, erfordern oder bei deren Geometrie bestimmte Maße von Längen, Winkeln oder/und Form- und Lagetoleranzen wie z.B. Ebenheit oder Parallelität eingehalten werden sollen, wird es oft notwendig sein, daß der Formkörper nach dem Abkühlen oberflächlich mechanisch nachbearbeitet wird, z.B. durch Schleifen, Läppen, Polieren oder/und Trommeln. Hierbei kann es auch sinnvoll sein, scharfe Kanten durch Schleifen mit einer Fase oder Verrundung bzw. durch Trommel mit einer Verrundung zu versehen.

Mit dem erfindungsgemäßen Verfahren lassen rich Formkörper aus einem Supraleitermaterial auf Basis von SEBaCuO mit SE mindestens ein Seltenerdelement, ausgewählt aus der Gruppe von Y, La, Ce, Pr, Nd, Eu, Gd, Tb, Dy, Ho, Er, Tm, Yb und Lu erhalten, die einen hohen Maximalwert der Remanenzinduktion bei 77 K und 0 T aufweisen können.

Vorzugsweise ist der Formkörper ein Zylinder, ein Ring, ein Rohr oder eine Scheibe im wesentlichen bestehend aus einem oder mehreren Segmenten, der eine Ausrichtung der c-Achsen der Körner oder des einen Korns aufweist im wesentlichen in Richtung der Zylinderachse/Plattenachse oder einer anderen Hauptrichtung des Formkörpers oder senkrecht zu ihr.

Der Formkörper kann im wesentlichen eine Zusammensetzung von $SE_1Ba_2Cu_3O_x$ mit x im Bereich von 6,5 bis 7 aufweisen, wobei SE im Überschuß auftreten kann. Vorteilhafterweise weist er zu mehr als 60 Vol.-%, besonders bevorzugt zu mehr als 70 oder zu mehr als 80 Vol.-%, eine Phase der Zusammensetzung $SE_1Ba_2Cu_3O_x$ mit x im Bereich von 6,5 bis 7 auf. Wird der Anteil der 211-Phase jedoch zu gering, können sich die supraleitenden Eigenschaften verschlechtern.

Der Formkörper kann eine kritische Transportstromdichte von mindestens $4 \times 10^4$ A/cm$^2$ im externen Feld von 1 T bei 77 K aufweisen, vorzugsweise von mindestens $6 \times 10^4$ A/cm$^2$, besonders bevorzugt von mindestens $8 \times 10^4$ A/cm$^2$ und insbesondere von mindestens $9,7 \times 10^4$ A/cm$^2$. Er kann auch eine Bruchzähigkeit ermittelt aus dem Rißsystem um Härteeindrücke von mindestens 1 MPa· $\sqrt{m}$ aufweisen, vorzugsweise von mindestens 1,5 MPa $\sqrt{m}$. Ferner kann er eine Biegebruchfestigkeit von mindestens 300 MPa, vorzugsweise von mindestens 400 MPa aufweisen.

Mit dem erfindungsgemäßen Verfahren gelang es, ohne Probleme eindomänige Formkörper mit z.B. 45 mm Durchmesser und 12 mm Höhe sowie z.B. 40 x 40 x 12 mm als quadratische Platten zu modifizieren (= zu vergüten).

Die erfindungsgemäß hergestellten Formkörper können beispielsweise für Transformatoren, Stromunterbrecher, Stromzuführungen, magnetische Abschirmungen, magnetische Lager oder/und als Magnete für unterschiedliche Zwecke verwendet werden.

Zeichnungen:

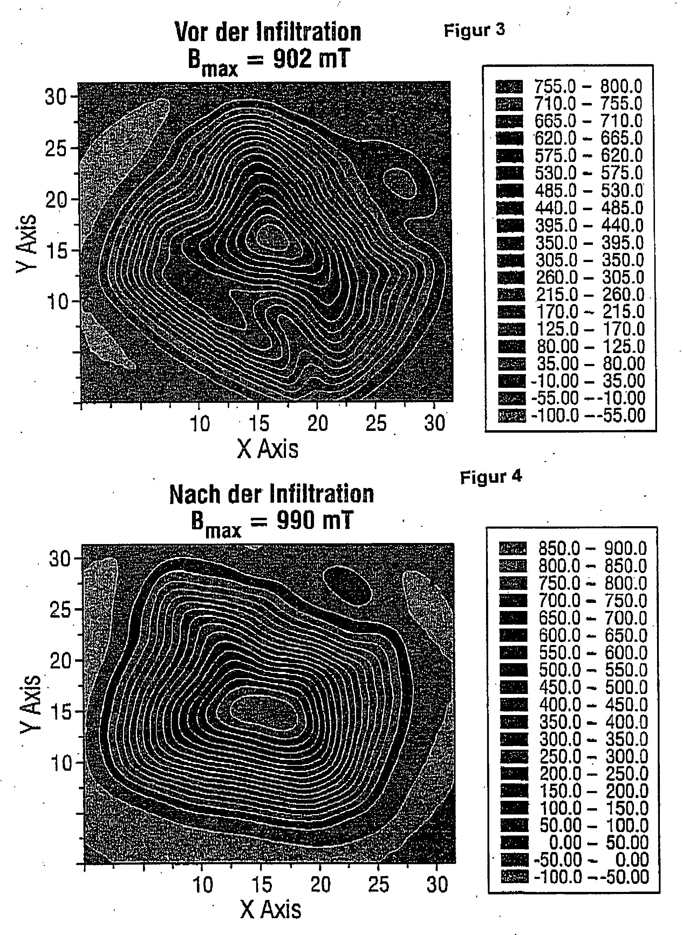

Die Figuren zeigen die Verteilung der magnetischen Remanenzinduktion zum Beispiel 1. Figuren 1 und 3 geben die Meßergebnisse des Vorläufermaterials und Figuren 2 und 4 die Meßergebnisse des erfingdungsgemäß vergüteten Supraleitermaterials wieder.

Beispiele:

Im folgenden werden die Meßmethoden aufgeführt und wird die Erfindung in ausgewählten Ausführungsformen beispielhaft dargestellt

Meßmethoden:

Messung der remanenten magnetischen Feldverteilung:

Zunächst wurde der aufzumagnetisierende supraleitende Formkörper bei Temperaturen oberhalb seiner Sprungtemperatur in das Feld eines konventionellen Elektromagneten eingebracht. Dabei drang das Magnetfeld voll in den in diesem zustand nicht supraleitenden Formkörper ein. Dann wurde der supraleitende Formkörper unter seine Sprungtemperatur $T_c$, in der Regel auf etwa 77 K, abgekühlt und anschließend das Feld des Elektromagneten vollständig heruntergefahren. Dabei blieb ein Teil des magnetischen Flusses, die Remanenzinduktion, im Supraleiter eingefroren. Die Messung der Verteilung dieser Remanenzinduktion erfolgte durch Abscannen der Formkörperoberfläche mittels einer HHP-VA Mikrohallsonde der Fa. Arepoc. Die aktive Fläche der Sonde war bis zu einer Temperatur von 4,2 K herab verwendbar. Die Messungen wurden üblicherweise nur bei 77 K ausgeführt. Um die Mikrohallsonde vor einem Kontakt mit der Formkörperoberfläche während der Messung zu schützen, wurde sie in einer PTFE-Halterung versenkt gehalten. Dadurch betrug der minimale Abstand der Sonde zur Formkörperobertläche bei der Messung 0,3 mm. Mit diesem Abstand wurde der Maximalwert der Remanenzinduktion ermittelt. Das Abscannen der Formkörperoberfläche für die Ermittlung der Verteilung der Remanzinduktion wurde mit einem Abstand von 0,5 mm durchgeführt.

Die PTFE-Halterung wurde über eine Edelstahlstange mit einem 3D-Positioniersystem verbunden. Die Steuereinheit des 3D-Positioniersystems war ein CNC-Controller C116-4 der Fa. Isel, weiche über eine RS 232-Schnittstelle von einem PC angesteuert werden konnte. Die Schrittmotoren konnten mit einer minimalen Schrittweite von 10 $\mu$m reproduzierbar positioniert werden. Der maximale Verfahrweg in X- und Y-Richtung betrug 32 cm, der in Z-Richtung 28 cm.

Zur Messung der Levitationskraft der supraleitenden Formkörper wurde ein Permanentmagnet aus 100 mm Höhe in Schritten von 0,5 mm auf die Oberfläche des auf 77 K abgekühlten Formkörpers abgesenkt und wieder in seine Ausgangsposition zurückgefahren. Der dabei verwendete Magnet war gemäß Standardisierung des Fachausschusses "Supraleitungswerkstoffe" der Deutschen Gesellschaft für Materialkunde (DGM) ein zylinderförmiger SmCo-Magnet mit einem Durchmesser von 25 mm, einer Höhe von 15 mm und einer Remanenz an der Oberfläche $B_z(0)$ von 0,4 T. Die Positionierung erfolgte mit dem im Verfahren zur Messung der Remanenzinduktion beschriebenen Positioniersystem. Für die PCgestützte Datenaufnahme wurde die mechanische Meßgröße Kraft in eine elektrische Meßgröße umgewandelt. Dazu wurde ein Dehnungsmeßstreifen-Sensor (DMS) KAP-S 0,05 der Fa. AST Dresden GmbH verwendet. Dieser Sensor wurde mit der maximal möglichen Spannung von 10 V betrieben; die zulässige Grenzkraft betrug 150 N. Die Auslesung der Meßdaten des Sensors erfolgte über ein digitales Multimeter, das vom PC über eine RS 232-Schnittstelle ausgelesen werden konnte.

Die Messung der Bruchzähigkeit konnte durch die Auswertung des von einem Vickers-Härteprüfkörper erzeugten Rißmusters erfolgen. Bei diesem nur bei spröden Materialien anwendbaren Verfahren wurden die Länge und die Konfiguration der im Härteprüfverfahren entstehenden Risse in Beziehung gesetzt zur eingesetzten Prüflast und zur ermittelten Härte des Materials. Die Härteeindrücke wurden dabei mit einem Leitz Durimed 2-Kleinlasthärteprüfer mit Lasten zwischen 10 g und 500 g bei einer Verweilzeit des Prüfkörpers auf der Oberfläche von 15 s erzeugt. Die Auswertung der Rißsysteme erfolgte mit einem Rasterelektronenmikroskop.

Messung des kritischen Transportstromes:

Die kritischen Transportstromdichten wurden nach der konventionellen Vierpunkt-Methode ermittelt. Dabei werden im Pulsbetrieb bei einer Pulsdauer von 1 ms Ströme bis zu einer Stärke von 400 A durch die Probe (Querschnittstläche 0,25 mm$^2$) geführt. Zur Kontaktierung wurden niederohmige Silberkontakte (0,04 mOhm) in die Probe eingebrannt

Beispiel 1 :

Es wurde ein Formkörper der Zusammensetzung $Y_1Ba_2Cu_3O_{7-x}$, der zusätzlich 25 mol% $Y_2O_3$ und 1 Gew.% $CeO_2$ enthielt, bei Temperaturen bis zu 1045 °C durch einen Schmelzwachstumsprozeß mit oben sitzendem Keim (top-seeded-melt-growth TSMG) hergestellt. Das Gefüge bestand aus YBCO 123 mit einer hohen Dichte an feinsten Partikeln von YBCO 211.
Die Abmessungen des fertig texturierten plattenförmigen Formkörpers betrugen 34 x 34 x 12 mm. Der Formkörper wies nach der Texturierung keine oberflächennahen makroskopischen Risse auf. Die nach der Texturierung gemessene Verteilung der Remanenzinduktion ergab einen Maximalwert der Remanenzinduktion $B_{z,max}$ von 820 mT (Figur 1), Die kegelförmige Geometrie dieser Verteilung zeigt die magnetische Eindomänigkeit des Formkörpers.
Dieser Formkörper wurde danach beschichtet und durch Infiltration erfindungsgemäß vergütet:
Zunächst wurde ein Auftragsmaterial, auch Infiltrat bezeichnet, der Ausgangszusammensetzung $Yb_1Ba_2Cu_3O_v$ durch Feinmahlung in ein sehr feinkörniges Pulver überführt und mit einem Spatel in einer Schichtdicke von etwa 2 mm auf die gesamte Formkörperoberfläche aufgebracht Dann wurde der Formkörper mit dem Auftragsmaterial folgender Temperaturbehandlung unterzogen:

1. Aufheizen in 3 h auf 900 °C

2. Aufheizen in 1 h auf 960 °C

3. Haltezeit 25 h bei 960 °C

4. Abkühlen in 70 h auf 890 °C mit einer Abkühlrate von 1 K/h

5. Abkühlen in 25 h auf 20°C.

Die nach der hierbei erfolgten Infiltration (= Vergütung) gemessene Verteilung der Remanenzinduktion ergab einen Maximalwert $B_{z,max}$ von 1026 mT (Figur 2).

Beispiel 2:

Es wurde wie in Beispiel 1 ein texturierter Formkörper mit Abmessungen 38x38x12 mm$^3$ hergestellt. Anders als in Beispiel 1 wurde als Auftragsmaterial Er-123 verwendet. Die nach der Texturierung gemessene Verteilung der Remanenzinduktion ergab einen Maximalwert der Remanenzinduktion $B_{z,max}$ von 902 mT (Figur3).
Dann wurde der Formkörper mit dem Auftragsmaterial folgender Temperaturbehandlung unterzogen:

1. Aufheizen in 12 h auf 900 °C

2. Aufheizen in 3 h auf 980 °C

3. Haltezeit 3 h bei 980 °C

4. Abkühlen in 2 h auf 970 °C

5. Haltezeit 10 h bei 970 °C

6. Abkühlen in 60 h auf 900 °C

7. Abkühlen in 30 h auf 25 °C.

Die nach der hierbei erfolgten Infiltration (= Vergütung) gemessene Verteilung der Remanenzindukftion ergab einen Maximalwert $B_{z,max}$ von 990 mT (Figur 4).

**Patentansprüche**

1. Verfahren zum Vergüten von Oberflächen von Formkörpern aus einem Supraleitermaterial auf Basis (SE)BaCuO mit SE mindestens ein Seltenerdelement einschließlich Lanthan und Yttrium,
**dadurch gekennzeichnet,**
**dass** auf mindestens einen Teil eines Bereichs einer Oberfläche des Formkörpers eine Beschichtung aus einem Auftragsmaterial aufgebracht wird, wobei das Auftragsmaterial zumindest teilweise bei einer tieferen Temperatur als das Formkörpermaterial schmilzt oder/und bei einer tieferen Temperatur als jenes Material fließfähig ist, wobei der Formkörper mit dem aufgebrachten Auftragsmaterial auf eine Temperatur aufgeheizt wird, bei der das Formkörpermaterial noch nicht schmilzt oder/und noch nicht fließfähig ist, aber bei der das Auftragsmaterial im zumindest teilweise aufgeschmolzenen oder/und fließfähigen Zustand ist und wobei mindestens ein Teil eines oberflächennahen Bereiches des Formkörpers bei dieser Temperatur oder/und einem nachfolgenden Abkühlen modifiziert wird, indem das Auftragsmaterial ganz oder teilweise zumindest in den oberflächennahen Bereich des Formkörpers eindiffundiert, und bei dem der derart behandelte Formkörper beim Abkühlen oder/und bei einer nachfolgenden Wärmebehandlung mit Sauerstoff angereichert wird, wobei die Modifizierung zur Erhöhung der Remanenzinduktion oder/und der kritischen Stromdichte des mit Sauerstoff angereicherten Formkörpers beiträgt, und wobei das Auftragsmaterial mindestens ein Seltenerdelement, ausgewählt aus der Gruppe bestehend aus Y, La, Ce, Pr, Nd, Eu, Gd, Tb, Dy, Ho, Er, Tm, Yb und Lu, sowie mindestens ein Erdalkalielement, Kupfer und Sauerstoff enthält.

2. Verfahren nach Anspruch 1,
**dadurch gekennzeichnet,**
**dass** das Supraleitermaterial mindestens ein Seltenerdelement einschließlich Lanthan und Yttrium sowie mindestens Barium, Kupfer und Sauerstoff und gegebenenfalls auch Elemente aus der Gruppe ausgewählt aus Be, Mg, Ca, Sr, Zn, Cd, Sc, Zr, Hf, Pt, Pd. Os, Ir, Ru, Cu, Ag, Au, Hg, Tl, Pb, Bi und S enthält.

3. Verfahren nach mindestens einem der vorhergehenden Ansprüche,
**dadurch gekennzeichnet,**
**dass** der Formkörper des Supraleitermaterials hergestellt wurde durch ein Schmelztexturierungsverfahren, durch ein Zonenschmelzverfahren, durch ein Einkristallzüchtungsverfahren oder durch Herstellung eines texturierten polykristallinen Supraleitermaterials.

4. Verfahren nach mindestens einem der vorhergehenden Ansprüche,
**dadurch gekennzeichnet,**
**dass** der Formkörper des Supraleitermaterials vor oder/und nach der Modifizierung ein bis hundert Körner oder/und ein bis hundert Domänen aufweist, vorzugsweise nur ein Korn und bis zu vier Domänen.

5. Verfahren nach mindestens einem der vorhergehenden Ansprüche,
**dadurch gekennzeichnet,**
**dass** der Formkörper des Supraleitermaterials vor oder/und nach der Modifizierung, das Auftragsmaterial vor oder/und nach der Modifizierung Phasen enthält, die ausgewählt sind aus der Gruppe von Phasen entsprechend einer annähernden Zusammensetzung von $Y_1Ba_2Cu_3O_v$, $Y_2Ba_1Cu_1O_w$, $Yb_1Ba_2Cu_3O_{v'}$, $Yb_2Ba_1Cu_1O_{w'}$, $Er_1Ba_2Cu_3O_{v'}$, $Er_2Ba_1Cu_1O_{w'}$, $Sm_1Ba_2Cu_3O_v$-, $Sm_2Ba_1Cu_1O_{w''}$, $Nd_1Ba_2Cu_3O_{v'''}$, $Nd_4Ba_2Cu_2O_{w'''}$, $Y_2O_3$, $CeO_2$, Pt, $PtO_2$, Ag und $AgO_2$, wobei Y, Yb, Sm oder/und Nd teilweise auch durch andere Lanthaniden oder Y substituiert sein können und wobei in Ag oder/und $AgO_2$ auch andere verwandte chemische Elemente auftreten können.

6. Verfahren nach mindestens einem der vorhergehenden Ansprüche,
**dadurch gekennzeichnet,**
**dass** der Formkörper des Supraleitermaterials vor oder/und nach der Modifizierung, das Auftragsmaterial vor oder/und nach der Modifizierung Calcium oder/und andere Kationen aufweist, die die Bandstruktur der Elektronen verändern und zu höheren kritischen Transportstromdichten beitragen.

7. Verfahren nach mindestens einem der vorhergehenden Ansprüche,
   **dadurch gekennzeichnet,**
   **dass** der Formkörper des Supraleitermaterials oder/und das Auftragsmaterial mindestens einen Gradienten bezüglich der chemischen Zusammensetzung, des Gefüges oder/und der peritektischen, Fließ- oder Schmelztemperatur aufweist.

8. Verfahren nach mindestens einem der vorhergehenden Ansprüche,
   **dadurch gekennzeichnet,**
   **dass** das Auftragsmaterial in einer Schichtdicke im Bereich von 1 $\mu$m und 5 mm, vorzugsweise 10 $\mu$m bis 3 mm, besonders bevorzugt von 50 $\mu$m und 2 mm, aufgebracht wird.

9. Verfahren nach mindestens einem der vorhergehenden Ansprüche,
   **dadurch gekennzeichnet,**
   **dass** als Auftragsmaterial ein Pulver, ein Formkörper oder/und eine Beschichtung aufgebracht wird - als Pulver vorzugsweise ein Pulvergemisch oder Granulat, als Formkörper vorzugsweise ein gepresster, kalzinierter, gesinterter oder erschmolzener Formkörper, als Beschichtung vorzugsweise eine physikalisch oder/und chemisch abgeschiedene, im wesentlichen durch Fällen, Sprühen bzw. Sprühpyrolyse hergestellte Beschichtung.

10. Verfahren nach mindestens einem der vorhergehenden Ansprüche,
    **dadurch gekennzeichnet,**
    **dass** ein pulverförmiges Auftragsmaterial aufgebracht wird, dass ein Formkörper des Auftragsmaterials auf die entsprechende Oberfläche des Formkörpers des Supraleitermaterials aufgesetzt wird oder/und dass aus der Gasphase, aus einer Lösung oder Suspension heraus bzw. mit einem Aerosol beschichtet wird.

11. Verfahren nach mindestens einem der vorhergehenden Ansprüche,
    **dadurch gekennzeichnet,**
    **dass** der beschichtete Formkörper des Supraleitermaterials so lange bei einer Temperatur entsprechend Anspruch 1 gehalten wird, daß ein Teil des Auftragsmaterials in das Supraleitermaterial eindiffundieren bzw. eindringen kann.

12. Verfahren nach mindestens einem der vorhergehenden Ansprüche,
    **dadurch gekennzeichnet,**
    **dass** bei der Modifizierung des Supraleitermaterials im Formkörper des Supraleitermaterials oder/und im aus dem Auftragsmaterial hergestellten Schichtmaterial ein Gradient erzeugt wird.

13. Verfahren nach mindestens einem der vorhergehenden Ansprüche,
    **dadurch gekennzeichnet,**
    **dass** der restliche Keim, das aus dem Auftragsmaterial hergestellte Schichtmaterial oder/und die unebene Oberfläche des Formkörpers nach der Modifzierung des Supraleitermaterials mechanisch entfernt wird und
    **dass** der Formkörper nachträglich ggf. einer Wärmebehandlung unterzogen wird.

14. Verfahren nach mindestens einem der vorhergehenden Ansprüche,
    **dadurch gekennzeichnet,**
    **dass** ein Formkörper des Supraleitermaterials im wesentlichen in Form von Platten, Vollzylindern, Hohlzylindern, Ringen, Scheiben, Stäben, Rohren, Drähten, Bändern oder Spulen hergestellt wird.

15. Verfahren nach mindestens einem der vorhergehenden Ansprüche,
    **dadurch gekennzeichnet,**
    **dass** der Formkörper des Supraleitermaterials während der Brände und Wärmebehandlungen im direkten Kontakt steht nur mit einem Supraleitermaterial auf Basis (SE)BaCuO mit SE mindestens ein Seltenerdelement einschließlich Lanthan und Yttrium, und ggf. mit einem Auftragsmaterial.

16. Verfahren nach mindestens einem der vorhergehenden Ansprüche,
    **dadurch gekennzeichnet,**
    **dass** ein großformatiger Formkörper des Supraleitermaterials mehrere in Abstand zueinander stehende Keime aufweist, deren c-Achsen entweder in einer der Hauptachsen oder Hauptrichtungen der Geometrie des Formkörpers oder senkrecht dazu orientiert stehen.

**17.** Verfahren nach mindestens einem der vorhergehenden Ansprüche,
**dadurch gekennzeichnet,**
**dass** ein großformatiger Formkörper des Supraleitermaterials in mehreren Segmenten hergestellt wird, die ggf. miteinander gefügt werden, insbesondere durch Wärmebehandlung bei einer Temperatur entsprechend Anspruch 1, ggf. unter Anwendung von Druck und ggf. unter Zusatz eines Auftragsmaterials auf den miteinander zu fügenden Grenzflächen.

**18.** Verwendung eines Formkörpers aus einem Supraleitermaterial hergestellt nach einem der Ansprüche 1 bis 17 auf Basis (SE)BaCuO mit SE mindestens ein Seltenerdelement einschließlich Lanthan und Yttrium für Transformatoren, Stromunterbrecher, Stromzuführungen, magnetische Abschirmungen, magnetische Lager oder/und als Magnete, insbesondere als Kryolager, in Schwungmassenspeichern, in Teilchenbeschleunigern, in Rotoren elektrischer Maschinen.

**Claims**

**1.** Process for coating surfaces of shaped bodies made of a superconducting material based on (SE)BaCuO with SE being at least one of rare earth element including lanthanum and yttrium,
**characterized in**
**that** to at least one part of a region of a surface of the shaped body a coating made of a coating material is applied, wherein the coating material at least partially melts at a lower temperature than the material of the shaped body and/or is flowable at a lower temperature than that of said material,
wherein the shaped body with the applied coating material is heated to a temperature at which the material of the shaped body does not yet melt and/or is not yet flowable, however at which the coating material is at least partially melted and/or is in a flowable state
and wherein at least one part of an area of the shaped body located near the surface is modified at said temperature and/or during successive cooling by total or partial diffusion of the coating material into at least the area located near the surface of the shaped body,
and wherein the shaped body treated in such a manner is enriched with oxygen during cooling and/or during a successive heat treatment,
whereby the modification contributes to the increase in remanent induction and/or to the critical current density of the shaped body enriched with oxygen,
and wherein the coating material contains at least one rare earth element selected from the group of Y, La, Ce, Pr, Nd, Eu, Gd, Tb, Dy, Ho Er, Tm, Yb and Lu as well as at least one alkaline earth element, copper ad oxygen.

**2.** Process according to claim 1, wherein the superconducting material comprises at least one rare earth element including Lanthanum and Yttrium as well as at least one of Barium, Copper and Oxygen and, optionally, elements selected from the group consisting of Be, Mg, Ca, Sr, Zn, Cd, Sc, Zr, Hf, Pt, Pd, Os, Ir, Ru, Cu, Ag, Au, Hg, Tl, Pb, Bi and S.

**3.** Process according to at least one of the preceding claims, wherein the shaped body of the superconducting material is produced by a melt-texture-growth process, a zone melting-process, a single crystal growth process or by production of a textured polycrystalline superconducting material.

**4.** Process according to at least one of the preceding claims, wherein the shaped body of the superconducting material comprises one to one hundred grains or/and one to one hundred domains, preferably only one grain and up to four domains, prior to or/and after the modification.

**5.** Process according to at least one of the preceding claims, wherein the shaped body of the superconducting material prior to or/and after the modification, the coating material prior to or/and after the modification includes phases which are selected from the group of phases having an approximate composition of $Y_1Ba_2Cu_3O_v$, $Y_2Ba_1Cu_1O_w$, $Yb_1Ba_2Cu_3O_{v'}$, $Yb_2Ba_1Cu_1O_{w'}$, $Er_1Ba_2Cu_3O_{v'}$, $Er_2Ba_1Cu_1O_{w'}$, $Sm_1Ba_2Cu_3O_{v''}$, $Sm_2Ba_1Cu_1O_{w''}$, $Nd_1Ba_2Cu_3O_{v'''}$, $Nd_4Ba_2Cu_2O_{w'''}$, $Y_2O_3$, $CeO_2$, Pt, $PtO_2$, Ag und $AgO_2$, wherein Y, Yb, Sm or/and Nd may also be partially substituted by other Lanthanides or Y, and wherein in Ag or/and $AgO_2$ other related chemical elements may also occur.

**6.** Process according to at least one of the preceding claims, wherein the shaped body of superconducting material prior to or/and after the modification, the coating material prior to or/and after the modification includes Calcium or/and other cations, which alter the band structure of the electrons and contribute to a higher critical transport current density.

7. Process according to at least one of the preceding claims, wherein the shaped body of the superconducting material or/and the coating material comprises at least one gradient in regard to the chemical composition, the grain structure or/and the peritectic flow or melting temperatures.

8. Process according to at least one of the preceding claims wherein the coating material is applied in a layer thickness in the range of $1 \mu m$ and 5 mm, preferably 10 $\mu m$ to 3 mm, particularly preferred from 50 $\mu m$ to 2 mm.

9. Process according to at least one of the preceding claims, wherein as the coating material a powder, a shaped body or/and a coating is applied - as the powder preferably a powder mixture or granulate, as a shaped body preferably a compressed, a calcinated, a sintered or a molten shaped body, as a coating preferably a physically or/and chemically deposited coating basically by precipitation, spraying or spray-pyrolysis.

10. Process according to any of the preceding claims, wherein a powder like coating material is applied, wherein a shaped body of the coating material is placed on the corresponding surface of the shaped body of the superconducting material, or/and wherein coating is effected from the gas phase, from a solution or suspension and with an aerosol, respectively.

11. Coating according to any of the preceding claims, wherein the coated shaped body of the superconducting material is maintained at a temperature of claim 1 until a portion of the coating material diffuses and penetrates, respectively, into the superconducting material.

12. Process according to at least one of the preceding claims, wherein during the modification of the superconducting material a gradient is produced in the shaped body of the superconducting material or/and in the layer of material produced from the coating material.

13. Process according to any of the preceding claims, wherein the residual nucleus, the layer of material produced from the coating material or/and the uneven surface of the shaped body is mechanically removed after modification of the superconducting material and wherein, optionally, the shaped body is subsequently subjected to a heat treatment.

14. Process according to at least one of the preceding claims, wherein the shaped body of superconducting material is substantially produced in the shape of plates, solid cylinders, hollowcylinders, rings, disks, bars, tubes, wires, tapes or coils.

15. Process according to any of the preceding claims, wherein during firering and heat treatment the shaped body of superconductor material is in direct contact only with a superconducting material based on (SE)BaCuO wherein SE is at least one rare earth element including Lanthanum and Yttrium and optionally with a coating material.

16. Process according to at least one of the preceding claims, wherein a large-sized shaped body of the superconducting material comprises a plurality of mutually spaced crystal nuclei whose c-axes are oriented either substantially parallel to one of the main axes or main directions of the geometry of the shaped body or are substantially at a right angle thereto.

17. Process according to at least one of the proceeding claims, wherein a large sized-shaped body of the superconducting material is produced in the form of a plurality of segments, which are possibly mutually jointed together, in particular by heat treatment at a temperature according to claim 1, possibly by the application of pressure and possibly by the addition of a coating material to the boundary surfaces that are to be joined together.

18. Use of a shaped body of a superconductor material produced according to any of the claims 1 to 17 based on (SE) BaCuO wherein SE is at least one rare earth element including Lanthanum and Yttrium in transformers, current breakers, power leads, magnetic screenings, magnetic bearings or/and as magnets, especially as cryogenic bearings, in flywheel storage devices, in particle accelerators, in the rotors of electrical machines.

**Revendications**

1. Procédé de trempe et revenu de surfaces de corps moulés en un matériau supraconducteur à base de (SE)BaCuO, SE étant au moins un élément de terres rares y compris le lanthane et l'yttrium,
**caractérisé en ce que** sur au moins une partie d'une zone de la surface du corps moulé, on applique un revêtement en un matériau d'apport, où le matériau d'apport fond au moins partiellement à une température inférieure à celle du matériau du corps moulé et/ou est fluide à une température inférieure à celle dudit matériau, où le corps moulé est chauffé avec le matériau d'apport appliqué à une température à laquelle le matériau du corps moulé ne fond pas encore et/ou n'est pas encore fluide, mais à laquelle le matériau d'apport est au moins partiellement fondu et/ou en un état fluide et où au moins une partie d'une zone proche de la surface du corps moulé est modifiée à cette température et/ou lors d'un refroidissement suivant, **en ce que** le matériau d'apport diffuse complètement ou partiellement, au moins dans la zone proche de la surface du corps moulé et où le corps moulé ainsi traité est enrichi d'oxygène lors du refroidissement et/ou lors d'un traitement thermique suivant, où la modification contribue à augmenter l'induction résiduelle et/ou la densité de courant critique du corps moulé enrichi en oxygène, et où le matériau d'apport contient au moins un élément de terres rares, choisi parmi le groupe consistant en Y, La, Ce, Pr, Nd, Eu, Gd, Tb, Dy, Ho, Er, Tm, Yb et Lu, ainsi qu'au moins un élément alcalino-terreux, le cuivre et l'oxygène.

2. Procédé selon la revendication 1, **caractérisé en ce que** le matériau supraconducteur contient au moins un élément de terres rares, y compris le lanthane et l'yttrium, ainsi qu'au moins du baryum, du cuivre et de l'oxygène et le cas échéant, également des éléments du groupe consistant en Be, Mg, Ca, Sr, Zn, Cd, Sc, Zr, Hf, Pt, Pd, Os, Ir, Ru, Cu, Ag, Au, Hg, Tl, Pb, Bi et S.

3. Procédé selon au moins l'une des revendications précédentes, **caractérisé en ce que** le corps moulé en matériau supraconducteur est préparé par un procédé d'extrusion à l'état fondu, par une rectification des zones, par un procédé de croissance de monocristal ou par préparation d'un matériau supraconducteur polycristallin texturé.

4. Procédé selon au moins l'une des revendications précédentes, **caractérisé en ce que** le corps moulé en matériau supraconducteur présente avant et/ou après la modification, un à cent grains et/ou un à cent domaines, de préférence seulement un grain et jusqu'à quatre domaines.

5. Procédé selon au moins l'une des revendications précédentes, **caractérisé en ce que** le corps moulé en matériau supraconducteur contient avant et/ou après la modification, des phases qui sont choisies parmi le groupe des phases correspondant à une composition approximative de $Y_1Ba_2Cu_3O_v$, $Y_2Ba_1Cu_1O_w$, $Yb_1Ba_2Cu_3O_{v'}$, $Yb_2Ba_1Cu_1O_{w'}$, $Er_1Ba_2Cu_3O_{v'}$, $Er_2Ba_1Cu_1O_{w'}$, $Sm_1Ba_2Cu_3O_{v''}$, $Sm_2Ba_1Cu_1O_{w''}$, $Nd_1Ba_2Cu_3O_{v'''}$, $Nd_4Ba_2Cu_2O_{w'''}$, $Y_2O_3$, $CeO_2$, Pt, $PtO_2$, Ag et $AgO_2$, où Y, Yb, Sm et/ou Nd peuvent être remplacés également partiellement par d'autres lanthanides ou Y, et où dans Ag et/ou $AgO_2$, d'autres éléments chimiques apparentés peuvent également se présenter.

6. Procédé selon au moins l'une des revendications précédentes, **caractérisé en ce que** le corps moulé en matériau supraconducteur présente avant et/ou après la modification, du calcium et/ou d'autres cations, qui modifient la structure de bande des électrons et qui contribuent à augmenter les densités de courant de transport critiques.

7. Procédé selon au moins l'une des revendications précédentes, **caractérisé en ce que** le corps moulé en matériau supraconducteur et/ou le matériau d'apport présente au moins un gradient concernant la composition chimique, la structure et/ou la température péritectique de fluidité ou de fusion.

8. Procédé selon au moins l'une des revendications précédentes, **caractérisé en ce que** le matériau d'apport est appliqué avec une épaisseur de couche située dans l'intervalle allant de 1 $\mu$m à 5 mm, de préférence de 10 $\mu$m à 3 mm, de manière particulièrement préférée de 50 $\mu$m à 2 mm.

9. Procédé selon au moins l'une des revendications précédentes, **caractérisé en ce que** comme matériau d'apport, on applique une poudre, un corps moulé et/ou un revêtement, comme poudre, de préférence un mélange pulvérulent ou un granulat, comme corps moulé de préférence un corps moulé pressé, calciné, fritté ou fondu, comme revêtement de préférence un revêtement précipité de manière physique et/ou chimique, préparé essentiellement par précipitation, pulvérisation et respectivement, pyrolyse par pulvérisation.

10. Procédé selon au moins l'une des revendications précédentes, **caractérisé en ce qu'**un corps moulé du matériau d'apport est disposé sur la surface correspondante du corps moulé du matériau supraconducteur et/ou qu'il est revêtu à partir de la phase gazeuse, à partir d'une solution ou suspension et respectivement, à l'aide d'un aérosol.

11. Procédé selon au moins l'une des revendications précédentes, **caractérisé en ce que** le corps moulé revêtu du matériau supraconducteur est maintenu à une température selon la revendication 1, tant qu'une partie du matériau d'apport peut diffuser ou pénétrer dans le matériau supraconducteur.

**12.** Procédé selon au moins l'une des revendications précédentes, **caractérisé en ce que** lors de la modification du matériau supraconducteur, un gradient est produit dans le corps moulé du matériau supraconducteur et/ou dans le matériau en couche préparé à partir du matériau d'apport.

**13.** Procédé selon au moins l'une des revendications précédents, **caractérisé en ce que** le germe restant, qui est éliminé mécaniquement du matériau en couche préparé à partir du matériau d'apport et/ou de la surface non plane du corps moulé après la modification du matériau supraconducteur et **en ce que** le corps moulé est soumis ultérieurement, le cas échéant à un traitement thermique.

**14.** Procédé selon au moins l'une des revendications précédentes, **caractérisé en ce que** le corps moulé en matériau supraconducteur est préparé essentiellement sous forme de plaques, cylindres pleins, cylindres creux, anneaux, disques, bâtons, tubes, fils, bandes ou bobines.

**15.** Procédé selon au moins l'une des revendications précédentes, **caractérisé en ce que** le corps moulé en matériau supraconducteur est en contact direct pendant la cuisson et les traitements thermiques, seulement avec un matériau supraconducteur à base de (SE) BaCuO avec SE étant au moins un élément de terres rares, y compris le lanthane et l'yttrium, et le cas échéant avec un matériau d'apport.

**16.** Procédé selon au moins l'une des revendications précédentes, **caractérisé en ce qu'**un corps moulé en matériau supraconducteur, de grand format présente plusieurs germes se trouvant à une certaine distance les uns des autres, dont les axes c sont orientés selon l'un des axes principaux ou des directions principales de la géométrie du corps moulé ou perpendiculairement à ceux-ci.

**17.** Procédé selon au moins l'une des revendications précédentes, **caractérisé en ce qu'**un corps moulé en matériau supraconducteur, de grand format, est préparé en plusieurs segments, qui sont le cas échéant joints l'un à l'autre, en particulier par traitement thermique à une température selon la revendication 1, le cas échéant sous pression et le cas échéant, avec addition d'un matériau d'apport sur les surfaces limites à joindre.

**18.** Utilisation d'un corps moulé en un matériau supraconducteur préparé selon l'une des revendications 1 à 17, à base de (SE)BaCuO avec SE étant au moins un élément de terres rares, y compris le lanthane et l'yttrium, pour des transformateurs, des interrupteurs, des amenées de courant, des blindages magnétiques, des paliers magnétiques et/ou comme aimant, en particulier comme palier cryogénique, dans des accumulateurs de masse d'inertie, dans des accélérateurs de particules, dans des rotors de machines électriques.

# Erhöhung der Remanenzinduktion
# durch Yb-Infiltration

## Vor der Infiltration
$B_{max} = 820$ mT

Figur 1

x (mm)

y (mm)

B (mT)

## Nach der Infiltration
$B_{max} = 1026$ mT

Figur 2

x (mm)

y (mm)

B (mT)

17

**Figur 3**

## Vor der Infiltration
## $B_{max} = 902$ mT

| | |
|---|---|
| ▦ | 755.0 – 800.0 |
| ▦ | 710.0 – 755.0 |
| ▦ | 665.0 – 710.0 |
| ▦ | 620.0 – 665.0 |
| ▦ | 575.0 – 620.0 |
| ▦ | 530.0 – 575.0 |
| ▦ | 485.0 – 530.0 |
| ▦ | 440.0 – 485.0 |
| ▦ | 395.0 – 440.0 |
| ▦ | 350.0 – 395.0 |
| ▦ | 305.0 – 350.0 |
| ▦ | 260.0 – 305.0 |
| ▦ | 215.0 – 260.0 |
| ▦ | 170.0 – 215.0 |
| ▦ | 125.0 – 170.0 |
| ▦ | 80.00 – 125.0 |
| ▦ | 35.00 – 80.00 |
| ▦ | -10.00 – 35.00 |
| ▦ | -55.00 – -10.00 |
| ▦ | -100.0 – -55.00 |

**Figur 4**

## Nach der Infiltration
## $B_{max} = 990$ mT

| | |
|---|---|
| ▦ | 850.0 – 900.0 |
| ▦ | 800.0 – 850.0 |
| ▦ | 750.0 – 800.0 |
| ▦ | 700.0 – 750.0 |
| ▦ | 650.0 – 700.0 |
| ▦ | 600.0 – 650.0 |
| ▦ | 550.0 – 600.0 |
| ▦ | 500.0 – 550.0 |
| ▦ | 450.0 – 500.0 |
| ▦ | 400.0 – 450.0 |
| ▦ | 350.0 – 400.0 |
| ▦ | 300.0 – 350.0 |
| ▦ | 250.0 – 300.0 |
| ▦ | 200.0 – 250.0 |
| ▦ | 150.0 – 200.0 |
| ▦ | 100.0 – 150.0 |
| ▦ | 50.00 – 100.0 |
| ▦ | 0.00 – 50.00 |
| ▦ | -50.00 – 0.00 |
| ▦ | -100.0 – -50.00 |

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19841925
- WO 0015581 A

- EP 1011153 A2

**In der Beschreibung aufgeführte Nicht-Patentliteratur**

- **IKUTA et al.** *Supercond. Sci. Techn.,* 1998, vol. 11, 1345-1347